Europäisches Patentamt

European Patent Office

Office européen des brevets

(19)

(11) **EP 1 560 337 A1**

(12) **EUROPEAN PATENT APPLICATION**

(43) Date of publication:
03.08.2005 Bulletin 2005/31

(51) Int Cl.[7]: **H03M 3/02**, H03M 3/04,
H03M 1/14

(21) Application number: 04001717.0

(22) Date of filing: 27.01.2004

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **Infineon Technologies AG**
**81669 München (DE)**

(72) Inventors:
• **Dias, Victor**
**85579 Unterbiberg (DE)**

• **Schwoerer, Christoph**
**85591 Vaterstetten (DE)**

(74) Representative:
**Graf Lambsdorff, Matthias, Dr. et al**
**Patentanwälte**
**Lambsdorff & Lange**
**Dingolfinger Strasse 6**
**81673 München (DE)**

(54) **Analog-to-digital converter comprising a sigma-delta modulator**

(57)    The invention relates to an analog-to-digital converter (ADC) comprising at least two quantization stages (stage 1, stage 2,..., stage N-1, SDM), wherein the final quantization stage (SDM) of said analog-to-digital converter (ADC) comprises a sigma-delta modulator (SDM).

FIG 1

**Description**

The invention relates to analog-to-digital converters. In particular, the invention deals with pipeline analog-to-digital converters and sigma-delta modulators.

An electronic device that performs a conversion from an analog signal to a digital sequence is called an analog-to-digital converter (ADC). Analog-to-digital converters are key blocks of modern medium to wideband wireless transceivers. Examples among others are the analog-to-digital converters required for the standards 802.11.a and HiperLAN-II (with a signal bandwidth of circa 20 MHz), UMTS and all its CDMA precursors and derivatives (with a signal bandwidth of circa 5 MHz) and Bluetooth (with a signal bandwidth of circa 1 MHz).

For the applications of the analog-to-digital converters mentioned above two architectures have essentially been used in prior art, namely the sigma-delta architecture and the pipeline architecture.

The sigma-delta architecture is mainly used in applications with a signal bandwidth of up to a few MHz as is the case of Bluetooth and wideband-CDMA.

The pipeline architecture is a member of the so-called Nyquist-rate ADC family. Pipeline analog-to-digital converters are mainly used in WirelessLAN applications, whose signal bandwidths are slightly smaller than 20 MHz.

Reducing the power consumption is one of the main targets when designing the architecture of an analog-to-digital converter as the power consumption directly impacts on the stand-by time and the active time of battery operated handheld devices, such as mobile phones, PDAs, headsets and notebook computers.

Although state-of-the-art pipeline and sigma-delta analog-to-digital converters can be considered nowadays to be very efficient in terms of power consumption, further improvements towards this direction need to be pursued.

It is an object of the present invention, therefore, to provide an analog-to-digital converter with reduced power consumption.

The above formulated object on which the invention is based is achieved by an analog-to-digital converter according to claim 1.

Preferred and advantageous embodiments of the analog-to-digital converter according to claim 1 are subject matter of claims 2 to 9.

The fundamental concept of the invention is to replace the final processing stage of an analog-to-digital converter comprising at least two quantization stages with a sigma-delta modulator. In other words, two or more quantization stages are arranged in a pipeline fashion and the last pipeline stage implementing the final quantization step comprises a sigma-delta modulator. In the following, the quantization stages preceding the sigma-delta modulator in the pipeline are also called front-end stages.

The invention is not restricted to any specific analog-to-digital converter architecture, it rather applies to any analog-to-digital converter architecture that makes use of two or more processing stages with coarse and fine quantizers. Various names for analog-to-digital converters with at least two quantization stages can be found in the literature. Examples of these names are sub-ranging, two- or multi-step, two- or multi-stage and pipeline analog-to-digital converter.

The invention is furthermore applicable to any sigma-delta modulator meaning that the sigma-delta modulator that implements the final quantization step can be of any order and can comprise any topology, band, number of quantization bits etc.

In accordance with an advantageous configuration of the invention, the at least two processing stages are connected in cascade.

According to another advantageous configuration of the invention the input terminal of the sigma-delta modulator is connected to an output terminal of the quantization stage that precedes the sigma-delta modulator in the pipeline. Therefore the sigma-delta modulator receives at its input the quantization noise at the output of the previous quantization stage and implements a noise-shaping of its own quantization noise. Since the front-end stages together have a high gain, when referred to the input the quantization noise generated by the sigma-delta modulator has a much lower power level compared to that produced by a conventional sigma-delta modulator, as it is divided by a gain $2^K$ of the front-end. Here the number K stands for the number of bits extracted of the front-end stages. The low-level quantization noise generated by the sigma-delta modulator is further shaped by the sigma-delta modulator.

The architecture of the analog-to-digital converter according to the invention results in advantages over conventional analog-to-digital converters listed in the subsequent paragraphs. For understanding these advantages, it has to be taken into consideration that in an ideal pipeline analog-to-digital converter, the quantization noise is due to the final processing stage only because the quantization noise of a quantization stage is always cancelled out by the next stage in the pipeline.

1. An N-bit pipeline analog-to-digital converter constructed according to the invention shows a signal-to-quantization noise ratio that is equivalent to a conventional (N+k)-bit architecture. The number k is a function of the oversampling factor and of the noise-shaping order implemented by the sigma-delta modulator. This will be explained below in more detail.

2. The in-band signal-to-quantization noise ratio of a conventional N-bit analog-to-digital converter can be achieved when using an (N-k)-bit pipeline analog-to-digital converter together with a sigma-delta modulator arranged at the end of the pipeline. Since k pipeline stages can be eliminated by the use of a low-order sigma-delta modulator, an analog-to-digital converter according to the invention requires less power and area than a conventional analog-to-digital converter with the same resolution.

3. Since the sigma-delta modulator will mostly implement a low-order noise shaping of its low-level quantization noise, the invention helps to reduce the complexity of the digital decimator with respect to that required by high-order sigma-delta modulators. Consequently power consumption and implementation area are drastically reduced.

4. The risk of having limit cycles in the sigma-delta modulator is largely reduced by the invention. The reason for this is that on the one hand the input signal of the sigma-delta modulator is pre-processed and randomised by the front-end stages and that on the other hand the weight of the bits delivered by the sigma-delta stage are attenuated by the overall gain of the front-end stages.

5. The quantization noise of the analog-to-digital converter according to the invention as a whole has less spurious tones than the quantization noise of the corresponding pipeline.

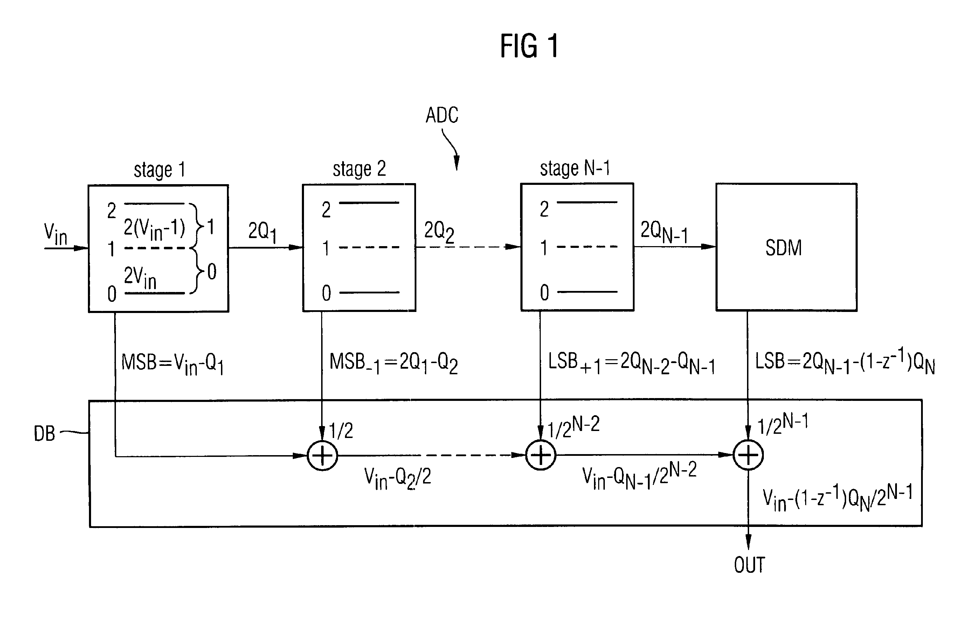

The invention is explained below in an exemplary manner with reference to the drawing, in which Fig. 1 shows the block diagram of an exemplary embodiment of the analog-to-digital converter according to the invention.

An analog-to-digital converter ADC, whose architecture is depicted in Fig. 1, comprises analog processing stages 1 to N-1, a sigma-delta modulator SDM and a digital block DB.

Each of the stages 1 to N-1 is a conventional 1-bit quantizer and gain-stage.

Together with the digital block DB the stages 1 to N-1 and the sigma-delta modulator SDM are connected in cascade.

In the following the function of the analog-to-digital converter ADC will be explained.

The stage 1 receives an analog input signal $V_{in}$ at its input. For ease of reference, the analog-to-digital converter ADC is assumed to have an input range between 0V and 2V.

The stage 1 implements a 1-bit quantization of the input signal $V_{in}$. Afterwards the stage 1 performs a subtraction of a reference and a multiplication by a factor of two. In more concrete terms this means:

If $V_{in} < 1$, the stage 1 extracts a "0" and sends it to the digital block DB. Furthermore the stage 1 delivers the signal $2V_{in}$ to the next stage in the pipeline, namely to the stage 2.

If $V_{in} >= 1$, the stage 1 extracts a "1" and sends it to the digital block DB. The stage 1 also delivers the signal $2(V_{in}-1)$ to the stage 2.

This also means that the quantization noise $Q_1$ amplified by a factor of 2 is passed to the stage 2. Thus the signal $2Q_1$ passed to the stage 2 is in the range between 0V and 2V. The bit MSB (most significant bit), which is sent to the digital block DB, consists of the input signal $V_{in}$ subtracted by the quantization noise $Q_1$.

The stage 2 performs the same basic operations as the stage 1. In particular, the stage 2 generates a bit $MSB_{-1}$ given by the term $2Q_1-Q_2$ and sends it to the digital block DB. The weight of the bit $MSB_{-1}$ is 1/2 of the weight of the bit MSB.

The stage 2 also calculates the term $2Q_2$ from its quantization noise $Q_2$ and passes this term to the next stage, namely to the stage 3.

After the addition of the bits MSB and $MSB_{-1}$ in the digital block DB the quantization noise $Q_1$ of the stage 1 is cancelled when considering the different weights of the bits MSB and $MSB_{-1}$.

The stages 3 to N-1 repeat the same operations previously performed by the stages 1 and 2. Finally the stage N-1 passes twice of its quantization noise $Q_{N-1}$ to the sigma-delta modulator SDM, which represents the last pipeline stage, and produces a bit $LSB_{+1}$. The bit $LSB_{+1}$ contains a term that cancels the quantization noise of all previous stages when added up with the bits produced by the previous stages 1 to N-2.

In the present exemplary embodiment of the invention the sigma-delta modulator SDM is a $1^{st}$ order sigma-delta modulator. The sigma-delta modulator SDM carries out a 1-bit quantization of its input signal $2Q_{N-1}$, while simultaneously high-pass-shaping its respective quantization error. The bit LSB (least significant bit) outputted by the sigma-delta modulator SDM contains the delayed input signal $2Q_{N-1}$ and the quantization noise $Q_N$ of the sigma-delta modulator SDM shaped by the term $1-z^{-1}$. Adding the bit LSB with the previously produced bits in the digital block DB leads to the cancellation of the quantization noise $Q_{N-1}$.

Since the quantization noise $Q_N$ of the sigma-delta modulator SDM is highpass shaped, filtering and decimation has the potential to bring additional bits of resolution if compared to conventional pipeline stages.

It should be noticed that the sigma-delta modulator SDM outputs two levels, +1 and -1. The reason for this is that the comparator inside the sigma-delta modulator SDM compares if its input signal $2Q_{N-1}$ is above or below zero and allocates the outputs +1 and -1 respectively. The quantization noise processed by the sigma-delta modulator SDM is in the range between -1 and +1, thus having a variance larger than a corresponding conventional pipeline stage. The effects of this will be discussed in more detail below.

The task of the digital block DB is to synchronise and to weight the output bits of the pipeline stages according to their position in the pipeline. The digital block DB outputs an N-bit word OUT, which is the output word of the analog-to-digital converter ADC.

In the following the design equations of the analog-to-digital converter ADC shown in Fig. 1 will be derived.

The oversampling factor M of a conventional pipeline analog-to-digital converter with an N-bit quantizer, a sampling rate $F_S$, an input range $V_{range}$ and a signal bandwidth B can be calculated as follows:

$$M = \frac{F_S}{2B} \tag{1}$$

The quantization step Q, the quantization noise power $P_Q$ and the power spectral density $P_{PSD}$, which is assumed to be constant over frequency, of a conventional pipeline analog-to-digital converter are given by the following equations:

$$Q = \frac{V_{range}}{2^N} \tag{2}$$

$$P_Q = \frac{Q^2}{12} \tag{3}$$

$$P_{PSD} = \frac{P_Q}{F_S} \tag{4}$$

In the full Nyquist band, the maximum achievable signal-to-noise ratio $SNR_{max\text{-}sinus}$ assuming a sinusoidal input signal ($P_{signal} = \frac{A^2}{2}$) is

$$SNR_{max\text{-}sin\,us} = \frac{P_{signal}}{P_Q}, \tag{5}$$

which is known to be 6N + 1.76 dB.

In a reduced signal bandwidth B, the signal-to-noise ratio $SNR_{in\text{-}band}$ is increased to

$$SNR_{in-band} = \frac{P_{signal}}{2\int_0^B P_{PSD}(f)df} = \frac{P_{signal}}{P_Q} M, \tag{6}$$

which corresponds to 6N + 10 log(M) + 1.76 dB. The processing gain is thus half a bit per octave of the oversampling factor M.

We assume that the input range of the conventional pipeline analog-to-digital converter is [0;2]. The bit outputted by the first stage is "1" if the input signal is above 1 and "0" if the input signal is below 1. The quantization error is then between 0 and 1 and the signal that is passed to the next stage is between 0 and 2. The second stage does exactly the same as stage 1, namely it extracts one bit, makes a quantization error in the range [0;1] and passes an amplified quantization error in the range [0;2] to the third stage. However, when referred to the input of the analog-to-digital converter, the quantization error of the second stage is divided by 2 and thus in the range [0;0.5]. If extrapolated to N stages, it can be concluded that the quantization noise of the Nth stage is in the range $[0;2/2^N]$ when referred to the input of the analog-to-digital converter. This agrees with the equation (2) for the quantization step Q and also validates the subsequent equations.

If the last pipeline stage of the analog-to-digital converter previously discussed is replaced with a 1st order sigma-delta modulator, the power spectrum of the quantization noise processed by the sigma-delta modulator is shaped by the transfer function $|1 - z^{-1}|^2$. This transfer function can be rearranged as follows:

$$\left|1 - z^{-1}\right|^2 = \left|1 - e^{-\frac{2\pi f}{Fs}}\right|^2 = \left|e^{-\frac{\pi f}{Fs}}\left(e^{\frac{\pi f}{Fs}} - e^{-\frac{\pi f}{Fs}}\right)\right|^2 = 4\sin^2\left(\frac{\pi f}{Fs}\right) \qquad (7)$$

However, it has to be taken into consideration that the quantization error processed by the sigma-delta modulator is twice as large as the quantization error processed by an equivalent, conventional pipeline stage. This can be explained by considering the quantization noise outputted by the pipeline stage preceding the sigma-delta modulator. As said above, the quantization noise processed by the stage N-1 is in the range [0;1] and the stage N-1 passes a signal in the range [0;2] to the sigma-delta modulator. The sigma-delta modulator first shifts its input signal to the range [-1;1] because its feedback pulses are 1 and -1. After the sigma-delta modulation an opposite shift is undertaken. Since the signal at the input of the comparator has a range which is typically up to [-1.5;1.5] or even slightly larger and the comparator outputs 1 and -1, it is easy to see that the quantization error can now be in the range [-1;1]. This range is a factor of 2 larger than the range previously derived for the conventional pipeline stage.

The application of equation (6) together with equation (7) leads to the following in-band signal-to-noise ratio $\text{SNR}_{\text{in-band}}$:

$$\text{SNR}_{\text{in-band}} = \frac{P_{\text{signal}}}{P_Q} M \frac{1}{8\left[1 - \frac{M}{\pi}\sin\left(\frac{\pi}{M}\right)\right]} \qquad (8)$$

In equation (8) the following factor can be identified as the processing gain PG:

$$PG = \frac{M}{8\left[1 - \frac{M}{\pi}\sin\left(\frac{\pi}{M}\right)\right]} \qquad (9)$$

In the conventional oversampling-only case, the processing gain PG would be simply the oversampling factor M.
The table shown below compares the processing gain PG obtained by an analog-to-digital converter according to the invention with plain oversampling. The results obtained with a 1st order and 2nd order sigma-delta modulator in the last pipeline stage are also listed.

| Oversampling Factor M | Proc. Gain PG (Plain Oversampling) | Proc. Gain PG (1st order Modulator) | Proc. Gain PG (2nd order Modulator) |
|---|---|---|---|
| 4 | 1.0 bit | 1.1 bit | 1.9 bit |
| 8 | 1.5 bit | 2.6 bit | 4.4 bit |
| 16 | 2.0 bit | 4.1 bit | 6.9 bit |
| 32 | 2.5 bit | 5.6 bit | 9.4 bit |

**Claims**

1. Analog-to-digital converter (ADC) comprising at least two quantization stages (stage 1, stage 2,..., stage N-1, SDM), wherein the final quantization stage (SDM) of said analog-to-digital converter (ADC) comprises a sigma-delta modulator (SDM).

2. The analog-to-digital converter (ADC) according to claim 1,
   **characterized in that**

   - said at least two quantization stages (stage 1, stage 2,..., stage N-1, SDM) are arranged in a cascade structure.

3. The analog-to-digital converter (ADC) according to claim 1 or according to claim 2,
   **characterized in that**

   - the input terminal of said sigma-delta modulator (SDM) is connected to the output terminal of the quantization stage (stage N-1) preceding said sigma-delta modulator (SDM),

   wherein the signal ($2Q_{N-1}$) outputted at said output terminal is a function of the quantization noise processed by said quantization stage (stage N-1).

4. The analog-to-digital converter (ADC) according to one or more of the preceding claims,
   **characterized in that**

   - said sigma-delta modulator (SDM) carries out a 1-bit quantization of its input signal.

5. The analog-to-digital converter (ADC) according to one or more of the preceding claims,
   **characterized in that**

   - said sigma-delta modulator (SDM) carries out highpass-shaping a quantization error of said sigma-delta modulator (SDM).

6. The analog-to-digital converter (ADC) according to one or more of the preceding claims,
   **characterized in that**

   - a least significant bit outputted by said sigma-delta modulator (SDM) contains a delayed input signal $2Q_{N-1}$ and a quantization noise $Q_N$ of said sigma-delta modulator (SDM) shaped by a term $1-z^{-1}$, wherein $Q_{N-1}$ is a quantization noise of the quantization stage (stage N-1) preceding said sigma-delta modulator (SDM).

7. The analog-to-digital converter (ADC) according to one or more of the preceding claims,
   **characterized in that**

   - said sigma-delta modulator (SDM) is a $1^{st}$ or $2^{nd}$ order sigma-delta modulator.

8. The analog-to-digital converter (ADC) according to one or more of the preceding claims,
   **characterized in that**

   - each of said at least two quantization stages (stage 1, stage 2,..., stage N-1, SDM) receives an input and provides a single output bit representative of its input,

   wherein a first quantization stage (stage 1) receives a converter input and provides a most-significant-bit output bit and the remaining quantization stages (stage 2,..., stage N-1, SDM) receive an amplified quantization noise signal from a preceding quantization stage (stage 1, stage 2,..., stage N-1).

9. The analog-to-digital converter (ADC) according to claim 8,
   **characterized in that**

   - said analog-to-digital converter (ADC) comprises a digital block (DB) coupled with said at least two quantization stages (stage 1, stage 2,..., stage N-1, SDM) and receiving the output bits from said at least two quantization stages (stage 1, stage 2,..., stage N-1, SDM).

# FIG 1

stage 1

$$2 \overline{\phantom{xx}}$$
$$\left.\begin{array}{c}2(V_{in}-1)\end{array}\right\}1$$
$$1 \overline{\phantom{xx}}$$
$$\left.\begin{array}{c}2V_{in}\end{array}\right\}0$$
$$0 \overline{\phantom{xx}}$$

$V_{in}$

ADC

stage 2

$2Q_1$

stage N-1

$2Q_2$

$2Q_{N-1}$

SDM

$MSB = V_{in} - Q_1$

$MSB_{-1} = 2Q_1 - Q_2$

$LSB_{+1} = 2Q_{N-2} - Q_{N-1}$

$LSB = 2Q_{N-1} - (1-z^{-1})Q_N$

DB

$1/2$

$1/2^{N-2}$

$1/2^{N-1}$

$V_{in} - Q_2/2$

$V_{in} - Q_{N-1}/2^{N-2}$

$V_{in} - (1-z^{-1})Q_N/2^{N-1}$

OUT

EP 1 560 337 A1

**European Patent Office**

## EUROPEAN SEARCH REPORT

Application Number

EP 04 00 1717

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 552 785 A (WILSON JAMES ET AL) 3 September 1996 (1996-09-03) | 1-5 | H03M3/02 H03M3/04 H03M1/14 |
| A | * figure 6 * | 6-9 | |
| X | PING WAH WONG ET AL: "TWO-STAGE SIGMA-DELTA MODULATION" IEEE TRANSACTIONS ON ACOUSTICS, SPEECH AND SIGNAL PROCESSING, IEEE INC. NEW YORK, US, vol. 38, no. 11, 1 November 1990 (1990-11-01), pages 1937-1952, XP000171013 ISSN: 0096-3518 * figure 2 * | 1,2,4,5 | |
| X | EP 0 515 154 A (AMERICAN TELEPHONE & TELEGRAPH) 25 November 1992 (1992-11-25) | 1,2 | |
| A | * the whole document * | 3-9 | |

TECHNICAL FIELDS SEARCHED (Int.Cl.7)

H03M

The present search report has been drawn up for all claims

| Place of search | Date of completion of the search | Examiner |
|---|---|---|
| MUNICH | 15 April 2004 | Henderson, R |

EPO FORM 1503 03.82 (P04C01)

## ANNEX TO THE EUROPEAN SEARCH REPORT
## ON EUROPEAN PATENT APPLICATION NO.

EP 04 00 1717

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2004

| Patent document cited in search report | | Publication date | Patent family member(s) | | Publication date |
|---|---|---|---|---|---|
| US 5552785 | A | 03-09-1996 | US | 5625358 A | 29-04-1997 |
| | | | US | 5497152 A | 05-03-1996 |
| | | | US | 5619202 A | 08-04-1997 |
| | | | US | 5485152 A | 16-01-1996 |
| | | | US | 5489903 A | 06-02-1996 |
| | | | EP | 0815647 A1 | 07-01-1998 |
| | | | WO | 9628889 A2 | 19-09-1996 |
| | | | US | 5528240 A | 18-06-1996 |
| | | | US | 5574454 A | 12-11-1996 |
| | | | EP | 0719477 A1 | 03-07-1996 |
| | | | JP | 9502847 T | 18-03-1997 |
| | | | WO | 9508220 A1 | 23-03-1995 |
| | | | WO | 9531860 A1 | 23-11-1995 |
| | | | US | 5963160 A | 05-10-1999 |
| | | | US | 5892468 A | 06-04-1999 |
| | | | DE | 69411926 D1 | 27-08-1998 |
| | | | DE | 69411926 T2 | 18-02-1999 |
| | | | EP | 0719478 A1 | 03-07-1996 |
| | | | JP | 9504917 T | 13-05-1997 |
| | | | WO | 9508221 A1 | 23-03-1995 |
| | | | US | 5712635 A | 27-01-1998 |
| | | | EP | 0759233 A1 | 26-02-1997 |
| | | | JP | 10511232 T | 27-10-1998 |
| | | | DE | 69510083 D1 | 08-07-1999 |
| | | | DE | 69510083 T2 | 05-01-2000 |
| | | | EP | 0793876 A1 | 10-09-1997 |
| | | | WO | 9616482 A1 | 30-05-1996 |
| | | | US | 5625359 A | 29-04-1997 |
| EP 0515154 | A | 25-11-1992 | US | 5144308 A | 01-09-1992 |
| | | | DE | 69215271 D1 | 02-01-1997 |
| | | | DE | 69215271 T2 | 05-06-1997 |
| | | | DE | 69231317 D1 | 07-09-2000 |
| | | | DE | 69231317 T2 | 28-12-2000 |
| | | | EP | 0515154 A1 | 25-11-1992 |
| | | | EP | 0709969 A2 | 01-05-1996 |
| | | | HK | 42997 A | 11-04-1997 |
| | | | JP | 2061726 C | 10-06-1996 |
| | | | JP | 5160736 A | 25-06-1993 |
| | | | JP | 7093582 B | 09-10-1995 |
| | | | KR | 9510212 B1 | 11-09-1995 |

EPO FORM P0459

For more details about this annex : see Official Journal of the European Patent Office, No. 12/82